# EUROPÄISCHE PATENTSCHRIFT

(11) **EP 0 474 010 B1**
(45) Veröffentlichungstag und Bekanntmachung des Hinweises auf die Patenterteilung: **05.11.1997**
(21) Anmeldenummer: 91113843.6
(22) Anmeldetag: 19.08.1991
(51) Int. Cl.: G03F 7/32, G03F 7/26

(54) **Entwicklerzusammensetzung für bestrahlte, strahlungsempfindliche, positiv und negativ arbeitende sowie umkehrbare reprographische Schichten und Verfahren zur Entwicklung solcher Schichten**
Developer composition for irradiated radiation-sensitive positive and negative working, as well as reversible reprographic layers and process for developing such layers
Composition de développement pour des couches reprographiques irradiées sensibles aux radiations à effets positifs et négatifs ainsi que réversibles et procédé de développement de telles couches

(30) Priorität: 29.08.1990 DE 4027299
(43) Veröffentlichungstag der Anmeldung: 11.03.1992
(73) Patentinhaber: Agfa-Gevaert AG, 51373 Leverkusen (DE)
(72) Erfinder: Buhr, Gerhard, Dr., Dipl.-Chem., W-6240 Königstein (DE); Elsässer, Andreas, Dr., Dipl.-Chem., W-6270 Idstein (DE); Frass, Hans Werner, Dr. Dipl.-Chem., W-6200 Wiesbaden-Naurod (DE); Leupold, Ernst Ingo, Dr. Dipl.-Chem., W-6392 Neu-Anspach (DE)

(56) Entgegenhaltungen:
- EP-A- 0 274 044
- EP-A- 0 279 630
- JP-A-61 185 745

## Beschreibung

Die Erfindung betrifft eine Entwicklerzusammensetzung für strahlungsempfindliche, positiv und negativ arbeitende sowie umkehrbare reprographische Schichten, die als wesentlichen Bestandteil neben der strahlungsempfindlichen Verbindung oder neben einer Kombination von solchen Verbindungen ein in Wasser unlösliches, in wäßrig-alkalischen Lösungen dagegen lösliches Bindemittel enthalten. Diese Entwicklerzusammensetzung weist besondere Vorteile hinsichtlich Ergiebigkeit, Entwicklungsgeschwindigkeit und Differenzierung zwischen den Bildstellen und den Nichtbildstellen auf und ist dabei frei von Schaumbildung und Niederschlägen. Sie ermöglicht eine harte Gradation bei der Verarbeitung von positiv arbeitenden, umkehrbaren und negativ arbeitenden Kopierschichten auf Photopolymer- oder Epoxidbasis.

Außerdem betrifft die Erfindung ein Verfahren zur Entwicklung der obengenannten reprographischen Schichten unter Verwendung dieser Entwicklerzusammensetzung.

Positiv arbeitende reprographische Schichten, in denen lichtempfindliche Verbindungen enthalten sind, die nach einer bildmäßigen Belichtung die belichteten Bereiche der Schicht in einer wäßrig-alkalischen Entwicklerlösung löslich machen, sind bekannt. Als lichtempfindliche Verbindungen werden in solchen Schichten in der Praxis vor allem 1,2-Chinondiazide verwendet, daneben können noch alkalilösliche Harze, z. B. Phenolharze, enthalten sein.

Reprographische Schichten auf der Basis von Verbindungen, die bei Bestrahlung Säure bilden, die ihrerseits säurespaltbare Verbindungen, wie Orthocarbonsäurederivate, monomere und polymere Acetale, Enolether, Silylether und Acyliminocarbonate, spaltet, sind ebenfalls bekannt. Als strahlungsempfindliche, Säure liefernde Verbindungen finden vorwiegend organische Halogenverbindungen, insbesondere halogenmethylsubstituierte s-Triazine Verwendung. Als Bindemittel werden wiederum alkalilösliche Harze verwendet.

Es ist auch bekannt, ein positiv arbeitendes Kopiermaterial auf der Basis von 1,2-Chinondiaziden, gegebenenfalls in Gegenwart geeigneter Zusatzstoffe, durch eine bestimmte Folge von Behandlungsschritten als negativ arbeitendes Kopiermaterial zu verwenden.

Bekannt ist ferner aus der EP-A 0 082 463 (= US-A 4 506 006) ein Positiv-Negativ-Umkehrverfahren auf der Basis säurespaltbarer Verbindungen anstelle von 1,2-Chinondiaziden.

Die bekannten Umkehrverfahren enthalten im Prinzip die gleiche Folge von Verarbeitungsschritten, d.h. nach dem bildmäßigen Belichten wird die Druckplatte erwärmt, anschließend abgekühlt, ohne Vorlage nachbelichtet und dann mit einem wäßrig-alkalischen Entwickler entwickelt.

Für die Praxis ist es von großer Bedeutung, daß die einzelnen Verarbeitungsschritte sicher gehandhabt werden können und die erhaltenen Ergebnisse in möglichst engen Grenzen reproduzierbar sind.

Als negativ arbeitende strahlungsempfindliche Gemische sind insbesondere zu nennen: Kombinationen aus ethylenisch ungesättigten Monomeren und Photoinitiatoren sowie aus Epoxidverbindungen und Substanzen, die bei Bestrahlung starke Säure bilden. Auch sind Kombinationen dieser Systeme bekannt. Diese reprographischen Schichten enthalten Bindemittel, die in wäßrig-alkalischen Lösungen löslich sind, bevorzugt Polykondensate oder Polymerisate mit seitenständigen Carboxylgruppen.

An eine Entwicklerzusammensetzung und ein Entwicklungsfahren für strahlungsempfindliche Schichten bzw. daraus hergestellten Aufzeichnungsmaterialien wird eine Reihe von Forderungen gestellt, von denen die folgenden hervorzuheben sind:
1. Die Ergiebigkeit der Entwicklerlösung soll hoch sein, d.h. das Verhalten des Entwicklers gegen die reprographische Schicht soll auch bei steigender Belastung des Entwicklers durch abgelöste Schichtbestandteile möglichst konstant bleiben und die Tongrenze, d.h. diejenige Belastung, bei der die Schicht nicht mehr vollständig abgelöst wird, soll möglichst hoch sein.
2. Der Entwicklungsprozeß soll bereits nach kurzer Einwirkzeit des Entwicklers abgeschlossen sein. Dies ist insbesondere von Bedeutung bei maschineller Verarbeitung mit Entwicklungsgeräten, die Bestandteil von Verarbeitungsstraßen sind. Bedingt durch kurze Taktzeiten bei der Verarbeitung liegen hierbei die Entwicklungszeiten zum Teil erheblich unter 30 Sekunden.
3. Die Entwicklungsresistenz soll gut sein, d.h. der Angriff der Entwicklerlösung gegen die unbelichtete Schicht bei der Positivverarbeitung bzw. gegen die belichtete Schicht bei der Negativverarbeitung bzw. gegen die belichtete und getemperte Schicht bei der Umkehrverarbeitung soll gering sein. Damit wird gewährleistet, daß auch bei mehrmaliger Entwicklung - beispielsweise bei Photocomposing-Arbeiten - eine Bildschädigung ausgeschlossen ist. Weiterhin wird damit sichergestellt, daß auch gealterte Kopierschichten noch einwandfrei verarbeitet werden können.
4. Beim Entwicklungsprozeß soll es weder Schaumbildung geben noch sollen Niederschläge auftreten, die die Entwicklungsgeräte verunreinigen und damit einen erhöhten Wartungsaufwand erforderlich machen.
5. Die Gradation, die durch die Art des Entwicklers stark beeinflußt wird, soll möglichst hart sein. Damit wird sowohl bei Positiv- als auch bei Negativverarbeitung eine bessere Punktwiedergabe erreicht.

Allgemein wird festgestellt, daß insbesondere bei der Umkehrverarbeitung die gleichzeitige Erfüllung aller Forderungen an den Entwickler erhebliche Probleme bereitet.

In der EP-A 0 101 010 (= US-A 4 530 895) wird eine wäßrig-alkalische Entwicklerlösung offenbart, die Silicat, Benzoat und quaternäre Ammoniumhydroxide enthält und bei der Entwicklung eine harte Gradation bewirkt. Da dieser Entwickler jedoch die Hydrophilie des Trägermaterials beeinträchtigt, wenn er zur Entwicklung von Druckplatten eingesetzt wird, ist seine Anwendung äußerst kritisch.

Der Zusatz nichtionischer Tenside, wie Fettsäureamide oder ethoxylierter Alkanole, Alkindiole und Phenole, zu der wäßrig-alkalischen Entwicklerlösung ist in der DE-A 32 23 386 (= US-A 4 374 920) und der US-A 3 586 504 beschrieben. Die Verwendung solcher Entwicklerlösungen führt zwar ebenfalls zu einer harten Gradation und ermöglicht kurze Entwicklungszeiten, bereitet allerdings durch das Auftreten von Niederschlägen mit Schichtbestandteilen die obengenannten Probleme.

Aus der EP-B 0 178 495 ist ein mehrstufiges Verfahren bekannt zum Entwickeln von bestrahlten, strahlungsempfindlichen, positiv arbeitenden Schichten, die Chinondiazidsulfonsäuren und alkalilösliches Harz enthalten, worin die bestrahlten Schichten mit wäßrig-alkalischen Lösungen, die einen Fluorkohlenstoff oder ein carboxyliertes oberflächenaktives Mittel enthalten, behandelt werden. Zu den carboxylierten oberflächenaktiven Mitteln werden auch (Poly-)glykole, die mit einem Fettalkohol und mit Hydroxyessigsäure, Hydroxypropionsäure oder Hydroxybuttersäure verethert sind, gezählt.

Mit den in den EP-A 0 178 496 und 0 209 153 beschriebenen wäßrig-alkalischen Entwicklern auf der Basis von O-Fettalkyl-O'-carboxymethyl-(poly-)ethylenglykol sowie den in der DE-A 39 15 141 genannten Arylethersulfaten werden zwar hervorragende Entwicklungsergebnisse erzielt, die starke Schaumbildung ist jedoch nicht akzeptabel.

In der EP-A 0 279 630 ist ein Entwickler für positiv und negativ arbeitende Kopierschichten auf der Basis von Chinondiaziden bzw. Diazoniumsalzen beschrieben, der eine alkalisch reagierende Substanz, ein Reduktionsmittel, ein nichtionisches oder kationisches Tensid sowie eine aromatische Carbonsäure, z.B. eine gegebenenfalls am aromatischen Ring substituierte Benzoesäure, enthält. Der Gehalt an nichtionischen bzw. kationischen Tensiden führt zu den oben aufgeführten Beeinträchtigungen bei der Verarbeitung. Außerdem sind keine Angaben zur Umkehrverarbeitung gemacht.

In der EP-A 0 274 044 wird eine Entwicklerlösung vorgestellt, die sich insbesondere zur Verarbeitung von umkehrbaren Kopierschichten eignet. Die Entwicklerlösung enthält als wesentliche Bestandteile Alkali, ein Ethylenoxid-Propylenoxid-Blockcopolymeres und gegebenenfalls einen Phosphatester, um Niederschlagsbildungen zu vermeiden. Mit dieser Entwicklerzusammensetzung werden gute Resultate auch bei Verarbeitung von umkehrbaren Kopierschichten erzielt. Da der Phosphatester-Zusatz jedoch bei den Mengen, die zugesetzt werden müssen, um eine Niederschlagsbildung sicher zu vermeiden, doch zu einer Schaumneigung der Entwicklerlösung führt, kann auch diese Zusammensetzung nicht als optimal bezeichnet werden.

Aufgabe der vorliegenden Erfindung ist es daher, eine Entwicklerzusammensetzung für strahlungsempfindliche, positiv und negativ arbeitende sowie umkehrbare reprographische Schichten, die als wesentlichen Bestandteil neben der strahlungsempfindlichen Verbindung bzw. Verbindungskombination ein in Wasser unlösliches, in wäßrig-alkalischen Lösungen aber lösliches Bindemittel enthalten, bereitzustellen, die die obengenannten Forderungen erfüllt.

Die Aufgabe besteht weiter darin, ein Verfahren zur Entwicklung von bestrahlten, strahlungsempfindlichen Schichten der vorgenannten Typen unter Verwendung einer solchen Entwicklerzusammensetzung zur Verfügung zu stellen.

Gelöst wird diese Aufgabe erfindungsgemäß durch einen Entwickler, der als wesentliche Bestandteile
a) O-Carboxymethyl- oder O,O'-Bis-carboxymethylethylenglykol oder ein O-Carboxymethyl- oder ein O,O'-Bis-carboxymethylpolyethylenglykol mit 2 bis etwa 500 Ethylenglykol-Einheiten,
b) mindestens eine in wäßriger Lösung alkalisch reagierende Verbindung aus der Gruppe der Alkali- und Ammoniumhydroxide, -silikate, -phosphate und -borate und
c) Wasser
enthält.

Das erfindungsgemäße Verfahren ist dadurch gekennzeichnet, daß man einen Entwickler, der diese drei Grundbestandteile enthält, zur Entwicklung von bestrahlten, strahlungsempfindlichen Schichten der obengenannten Typen verwendet.

Besonders bevorzugt sind O-Carboxymethyl- oder O,O'-Bis-carboxymethyl-polyethylenglykole aus etwa 5 bis etwa 50 Ethylenglykoleinheiten. Grundsätzlich sind auch O-Carboxymethyl-(poly-)ethylenglykole, die mit Methanol, Ethanol, Propanol, Butanol oder anderen Hydroxyverbindungen verethert sind, geeignet. Entscheidend ist, daß die Verbindungen keinen Tensidcharakter besitzen. Der Gehalt des Entwicklers an verethertem (Poly-)ethylenglykol richtet sich zum einen nach dem Kondensationsgrad des Polyethersegments (bei hohen Kondensationsgraden sind geringere Mengen erforderlich), zum anderen nach der Art und Menge der weiteren dem Entwickler zugesetzten Substanzen, dem pH-Wert sowie der Art der zu verarbeitenden Kopierschicht. Die optimale Menge ist in Einzelversuchen zu ermitteln; in der Regel sind 0,01 bis 20 Gew.-%, bevorzugt 0,1 bis 10 Gew.-%, bezogen auf das Gesamtgewicht der Zusammensetzung, ausreichend. Die Herstellung der (formal) mit Hydroxyessigsäure veretherten (Poly-)ethylenglykole erfolgt entweder durch Williamson-Ether-Synthese aus den entsprechenden Glykolen und Chloressigsäure oder, vorteilhafter, durch Oxidation, gegebenenfalls in Anwesenheit von Katalysatoren, wie beispielsweise in der DE-A 29 36 123 beschrieben.

Unter den alkalisch reagierenden Verbindungen sind Alkalihydroxide, Ammoniumhydroxid und Tetraalkylammonium-hydroxid sowie - wenn der Kopierschichtträger von Hydroxylionen angegriffen wird - Alkali- und Ammoniumsilikate bevorzugt. Die erforderliche Menge ist auf die zu verarbeitenden Kopierschichten abzustimmen, in der Regel sind 1 bis 20 Gew.-%, bevorzugt 5 bis 10 Gew.-%, bezogen auf das Gesamtgewicht der Zusammensetzung, hinreichend.

Über die genannten Verbindungen hinaus kann je nach Art der zu verarbeitenden Kopierschichten die Zugabe weiterer Additive zum Entwickler sinnvoll sein.

Wenn sehr kurze Entwicklungszeiten erreicht werden sollen oder wenn der zu verarbeitende Anteil an negativ arbeitenden Kopierschichten hoch ist, ist es sinnvoll, Lösemittel, insbesondere Alkohole wie Glykolether, zuzusetzen. Da durch den Lösemittelzusatz im allgemeinen aber die Resistenz der Kopierschicht gegen den Entwickler abnimmt, sollte sich die zugesetzte Menge an Lösemittel vorzugsweise unter 2 Gew.-% bewegen.

Weiterhin kann die Zusammensetzung eine oder mehrere oberflächenaktive Substanz(en) enthalten. Sie dienen zur Einstellung der Oberflächenspannung. Insbesondere bei Sprühantrag ist eine Oberflächenspannung von maximal 50 mN/m anzustreben, um eine rasche Benetzung der Kopierschicht zu gewährleisten. Grundsätzlich sind dafür sowohl kationische wie anionische, aber auch zwitterionische und nichtionische Tenside oder Tensidkombinationen geeignet.

Für den Fall, daß der Entwickler in Form eines Konzentrats zur Verfügung gestellt wird, das vor Gebrauch mit Wasser verdünnt werden muß, enthält das Konzentrat zweckmäßig Sequestrierungsmittel, d.h. Mittel, die mehrwertige Metallionen in einen anionischen Komplex binden, um Fällungen zu vermeiden, wenn mit hartem Wasser verdünnt wird. Diese Weichmacher für hartes Wasser sind insbesondere Phosphate wie Na₂P₂O₇, Na₅P₃O₃, Na₃P₃O₉, Na₂O₄P(NaO₃P)PO₃Na₂ und Calgon (Natriumpolymetaphosphat), Polyaminocarbonsäuren oder Salze hiervon, wie Ethylendiamintetraessigsäure und ihre Natrium- und Kaliumsalze, Diethylentriaminpentaessigsäure und ihre Natrium- und Kaliumsalze, Triethylentetraminhexaessigsäure und ihre Natrium- und Kaliumsalze, Hydroxyethylethylendiamintriessigsäure und ihre Natrium- und Kaliumsalze, Nitrilotriessigsäure und ihre Natrium- und Kaliumsalze, Cyclohexan-1,2-diamintetraessigsäure und ihre Natrium- und Kaliumsalze und 2-Hydroxypropan-1,3-diamintetraessigsäure und ihre Natrium- und Kaliumsalze. Diese Weichmacher können allein oder in Kombination verwendet werden. Die davon verwendete optimale Menge variiert in Abhängigkeit von Härtegrad und Menge des (zugesetzten) Wassers, jedoch liegt sie im allgemeinen im Bereich von 0,01 bis 0,5 Gew.-%, bezogen auf das Gesamtgewicht des gebrauchsfertigen Entwicklers.

Wenn die Kopierschichtträger von den alkalischen Entwicklerlösungen angegriffen werden können, wie beispielsweise im Falle anodisierter Aluminiumfolien, so ist der Zusatz von Korrosionsinhibitoren vorteilhaft. Hierfür haben sich insbesondere die in der DE-A 28 34 958 und in der EP-A 0 071 823 beschriebenen Metallsalze bewährt sowie die in der EP-A 0 071 823 genannten Lithiumverbindungen.

Weiterhin können hydrotrope Substanzen, wie Arylsulfonate, -carboxylate oder Phosphatester zugesetzt werden, wenn dem Entwickler etwa zur Verbesserung der Entwicklerresistenz der Kopierschicht Additive zugesetzt wurden, die unter Umständen zu einer Niederschlagsbildung beim Entwicklungsprozeß führen können.

Falls größere Mengen an Tensiden im Entwickler enthalten sind, wird dem Entwickler zweckmäßig ein Antischaummittel zugesetzt.

Die verwendeten strahlungsempfindlichen Kopierschichten bzw. Aufzeichnungsmaterialien sowie die erforderlichen Verfahrensschritte zu ihrer Verarbeitung werden wie folgt beschrieben:

Als positiv arbeitende Schichten werden bevorzugt solche auf der Basis von 1,2-Chinondiaziden, insbesondere Estern oder Amiden von 1,2-Naphthochinon-2-diazid-4- oder -5-sulfonsäure oder -carbonsäure verwendet. Geeignete Verbindungen dieser Art sind z. B. aus der DE-C 938 233 (= GB-A 739 654) bekannt.

Umkehrbare Schichten enthalten bevorzugt die 1,2-Naphthochinon-2-diazid-4-sulfonsäurederivate sowie weitere, den Verarbeitungsspielraum bei der Umkehr fördernde Zusätze wie in den DE-A 37 11 263 und der nicht vorveröffentlichten deutschen Patentanmeldung P 40 04 719.9 beschrieben.

Weiterhin können auch Schichten, die positiv arbeiten und umkehrbar sind, verwendet werden, in denen eine Kombination von Verbindungen mit mindestens einer durch Einwirkung von Säure spaltbaren C-O-C-Bindung und einer Verbindung, die bei Bestrahlung starke Säure bildet, enthalten ist.

Als durch Säure spaltbare Verbindungen sind in erster Linie zu nennen:
a) Orthocarbonsäureester und Carbonsäureamidacetale, die auch polymeren Charakter haben können und die Orthoester- oder Amidacetalgruppierungen als verknüpfende Elemente in der Hauptkette oder seitenständig enthalten,
b) Oligomer- oder Polymerverbindungen mit wiederkehrenden Acetal- und/oder Ketalgruppierungen in der Hauptkette,
c) Verbindungen mit mindestens einer Enolether- oder Acyliminocarbonatgruppierung und
d) Verbindungen mit mindestens einer Silylethergruppierung

Durch Säure spaltbare Verbindungen des Typs a) als Komponenten strahlungsempfindlicher Gemische sind in der EP-A 0 033 571 (= US-A 4 311 782) beschrieben; Gemische, die Verbindungen des Typs b) enthalten, sind in der DE-C 23 06 248 (= US-A 3 779 778) genannt; Verbindungen des Typs c) sind aus der EP-A 0 006 627 (= US-A 4 248 957) bekannt; Verbindungen des Typs d) sind in der EP-A 0 130 599 und den DE-A 35 44 165 und 36 28 046 beschrieben.

Als lichtempfindliche Komponenten, die beim Belichten starke Säure bilden, sind eine große Anzahl von bekannten Verbindungen und Mischungen, wie Phosphonium-, Sulfonium- und Jodoniumsalze, Halogenverbindungen und Organometall-Organohalogen-Kombinationen geeignet.

Die genannten Phosphonium-, Sulfonium- und Jodoniumverbindungen werden in der Regel eingesetzt in Form ihrer in organischen Lösemitteln löslichen Salze, meist als Abscheidungsprodukt mit Hexafluorphosphor-, Hexafluorantimon- und -arsensäure.

Grundsätzlich sind als halogenhaltige lichtempfindliche und Halogenwasserstoffsäure bildende Verbindungen alle auch als photochemische Radikalstarter bekannten organischen Halogenverbindungen, beispielsweise solche, die mindestens ein an ein Kohlenstoffatom oder einen aromatischen Ring gebundenes Halogenatom enthalten, brauchbar. Von diesen Verbindungen werden die s-Triazinderivate, die mit Halogenmethylgruppen, insbesondere Trichlormethylgruppen, und mit einem aromatischen bzw. ungesättigten Rest substituiert sind, wie in der DE-A 27 18 259 (= US-A 4 189 323) beschrieben, bevorzugt. Ebenso geeignet sind 2-Trichlormethyl-[1,3,4]oxadiazole(DE-A 28 51 471 = US-A 4 212 970). Die Wirkung dieser halogenhaltigen Verbindungen kann auch durch bekannte Sensibilisatoren spektral beeinflußt und gesteigert werden.

Als Bindemittel werden in diesen Schichten z. B. Polykondensate oder Polymerisate mit freien phenolischen Hydroxylgruppen eingesetzt, wobei der Gehalt an phenolischen Hydroxylgruppen bevorzugt im Bereich zwischen 2 und 9 mmol/g Bindemittel liegt. Als Beispiele für Polykondensate sind Phenolharze vom Novolaktyp oder hydroxy-substituierte Aramide zu nennen. Als Beispiele für Polymerisate seien genannt: Homo- und Copolymerisate von Vinylphenolen (DE-A 23 22 230 = US-A 3 869 292), Polymerisate der Ester von Acrylsäuren mit Phenolen (EP-A 0 212 439) oder Copolymerisate von Hydroxyphenyl-maleinimiden (EP-A 0 187 517). Weiterhin können Bindemittel mit N-H-aciden Gruppen eingesetzt werden, wie in der US-A 4 720 445 oder der DE-A 34 45 276 beschrieben.

Als negativ arbeitende Gemische sind insbesondere solche zu nennen, die eine Kombination darstellen aus olefinisch ungesättigten Verbindungen, insbesondere Acryl- oder Methacrylsäureestern mehrwertiger Alkohole, und Photoinitiatoren oder eine Kombination aus Verbindungen, die bei Bestrahlung eine starke Säure bilden, und Verbindungen, die in Gegenwart von Säure eine Polyaddition eingehen. Auch sind Kombinationen verschiedener Wirkprinzipien möglich, wie in den EP-A 0 167 933 und 0 184 725 beschrieben.

Als Bindemittel in den negativ arbeitenden Gemischen können im Prinzip dieselben Harze eingesetzt werden wie oben beschrieben. Bevorzugt werden jedoch Harze mit seitenständigen Carboxylgruppen eingesetzt, wie z. B. in den DE-A 34 04 366 und 36 38 757 beschrieben.

Weiterhin kann die lichtempfindliche Schicht für spezielle Erfordernisse, wie Flexibilität, Haftung, Glanz etc., außerdem noch Substanzen wie Polyglykole, Celluloseether, z. B. Ethylcellulose, Netzmittel etc. enthalten.

Ferner können dem lichtempfindlichen Gemisch noch Farbstoffe oder auch feinteilig dispergierbare Pigmente zugesetzt werden.

Als Schichtträger für Schichtdicken unter ca. 10 µm werden meist Metalle verwendet. Für Offsetdruckplatten können eingesetzt werden: walzblankes, mechanisch und/oder elektrochemisch aufgerauhtes und gegebenenfalls anodisiertes Aluminium, das zudem noch chemisch, z.B. mit Polyvinylphosphonsäure, Silikaten, Phosphaten, Hexafluorzirkonaten oder mit hydrolysiertem Tetraethylorthosilikat vorbehandelt sein kann.

Die Beschichtung des Schichtträgers erfolgt in bekannter Weise durch Aufschleudern, Sprühen, Tauchen, Walzen, mittels Breitschlitzdüsen, Rakeln oder durch Gießer-Antrag.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Belichtung bzw. Bestrahlung ist in dieser Beschreibung die Einwirkung aktinischer elektromagnetischer Strahlung in Wellenlängenbereichen unterhalb etwa 500 nm zu verstehen. Alle in diesem Wellenlängenbereich emittierenden Strahlungsquellen sind prinzipiell geeignet.

Mit Vorteil können auch Laserbestrahlungsgeräte, insbesondere automatische Verarbeitungsanlagen verwendet werden, die als Strahlungsquelle, z.B. einen Argon- oder Krypton-Ionen-Laser enthalten. Die Bestrahlung kann ferner mit Elektronenstrahlen erfolgen. Auch Röntgenstrahlen können zur Bilderzeugung verwendet werden.

Die bildmäßig belichtete oder bestrahlte bzw. die vollflächig bestrahlte Schicht kann in bekannter Weise mit den oben beschriebenen Entwicklern verarbeitet werden.

Bevorzugt wird diese Entwicklung in Sprüh-, Stau- oder Tauchbad-Entwicklungsgeräten bei Temperaturen von 18 bis 50 °C und in Zeiten von 5 Sekunden bis zu einer Minute durchgeführt.

An die Entwicklung können sich weitere Verarbeitungsschritte anschließen, beispielsweise bei Druckplatten eine Hydrophilierung mit sauren Lösungen, das Aufbringen von Konservierungsschichten oder, wenn zur Erhöhung der Widerstandsfähigkeit beim Druck sowie der Resistenz gegen Auswaschmittel, Korrekturmittel und durch UV-Licht härtbare Druckfarben die entwickelten Platten kurzzeitig auf erhöhte Temperaturen erwärmt werden sollen, wie es für Diazoschichten aus der GB-A 1 154 749 bekannt ist, das Auftragen von sogenannten Einbrenngummierungen.

Im folgenden werden Beispiele der bevorzugten Ausführungsformen angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

### Herstellung von strahlungsempfindlichen Formulierungen

Entsprechend Tabelle 1 werden Beschichtungslösungen hergestellt und auf aufgerauhte, dann in Schwefelsäure anodisierte und schließlich mit Polyvinylphosphonsäure hydrophilierte Aluminiumfolien aufgeschleudert. Die Umdrehungszahl der Schleuder wird so gewählt, daß nach 2 Minuten Trocknen bei 100 °C Schichtdicken von 2 µm resultieren.

Auf die mit den Gemischen 4, 5 und 7 beschichteten Materialien wird dann noch eine nicht lichtempfindliche Deckschicht aus Polyvinylalkohol (K-Wert 4, Restacetylgruppengehalt 12 %) aus Wasser in einer Stärke von 0,2 µm aufgebracht.

Diese Deckschicht ist für die Gemische, die auf der Basis säurekatalysierter Spaltung von C-O-C-Bindungen arbeiten, vorteilhaft, um eine vorzeitige Alterung der Kopierschicht zu verhindern und einen breiten Temperaturbereich für die Nacherwärmung bei Positivverarbeitung zu gewährleisten (vgl. DE-A 37 15 790). Für die photopolymerisierbare Kopierschicht dient sie als Sauerstoffbarriere (vgl. DE-C 15 72 162).

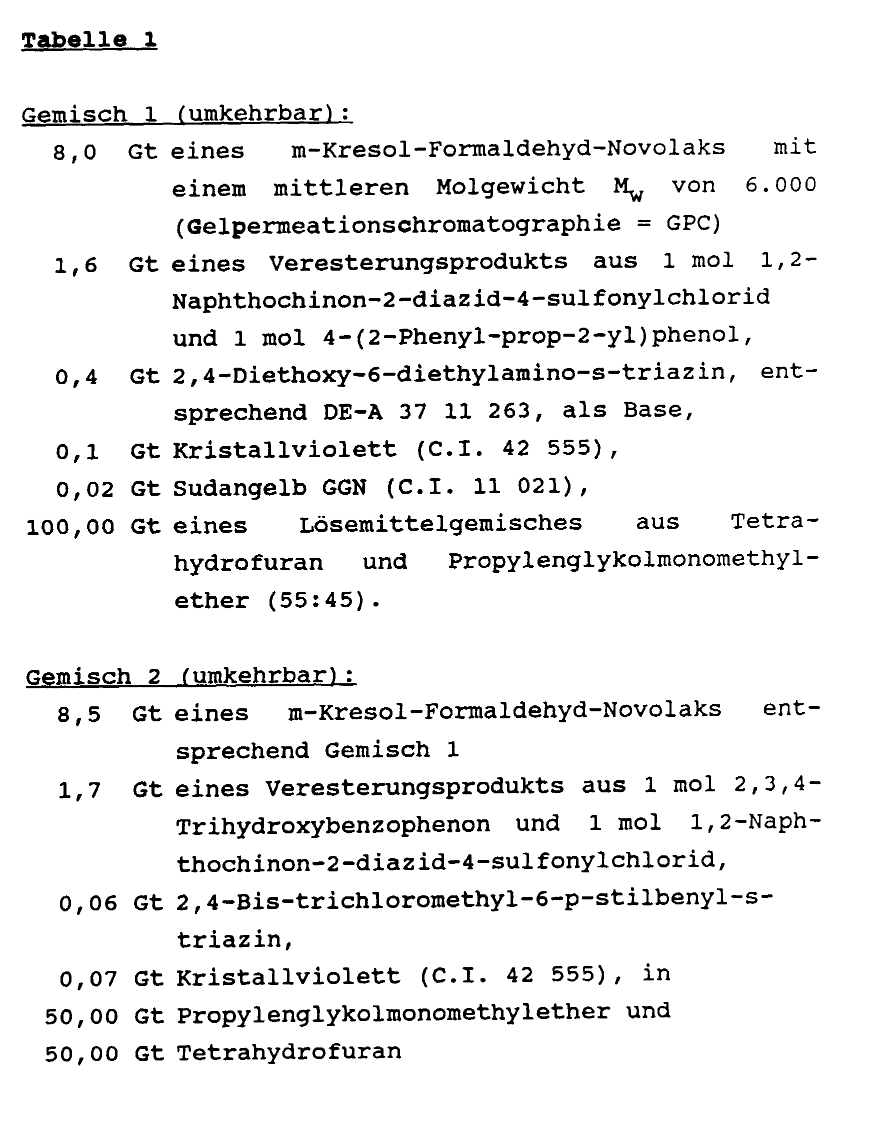

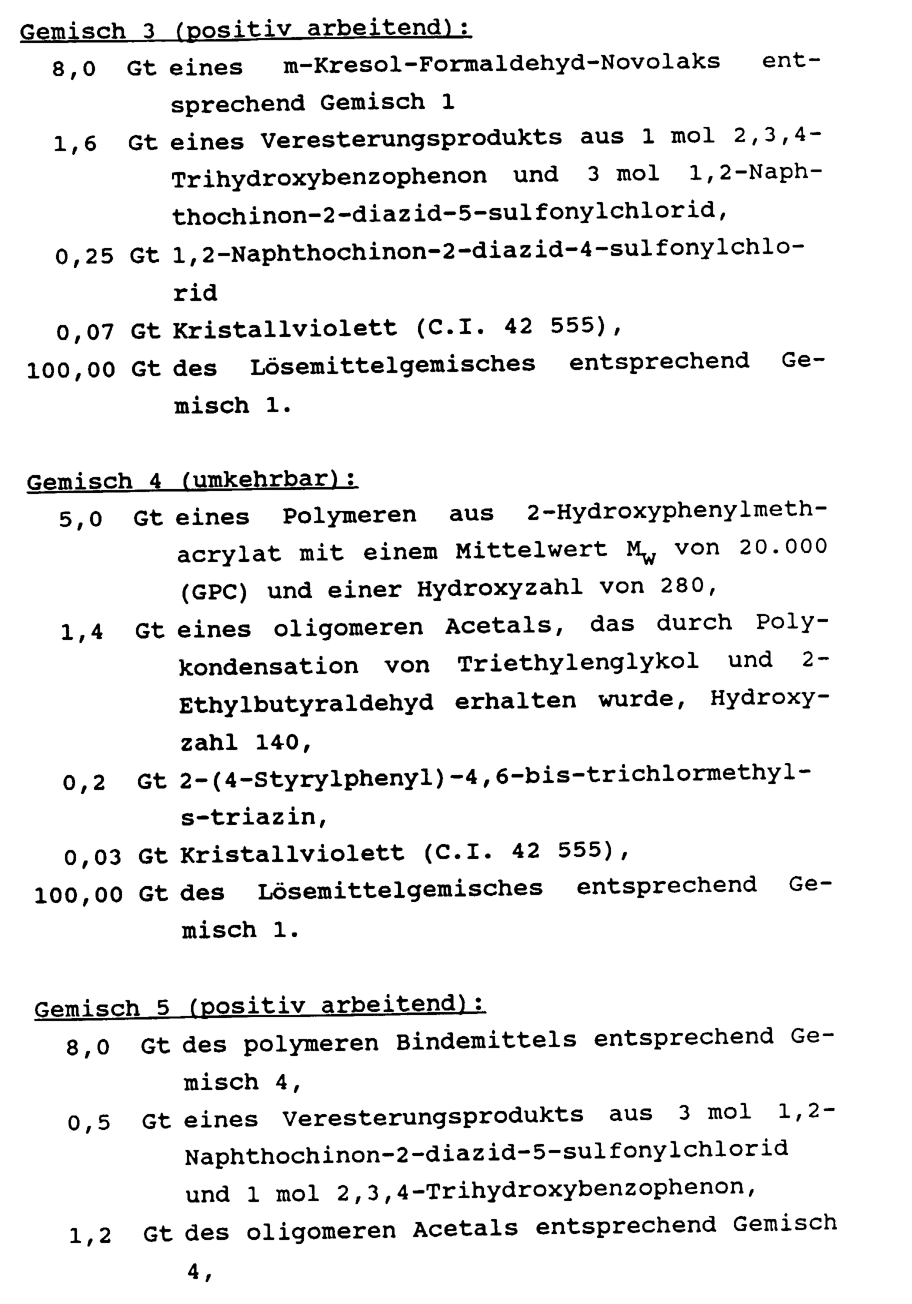

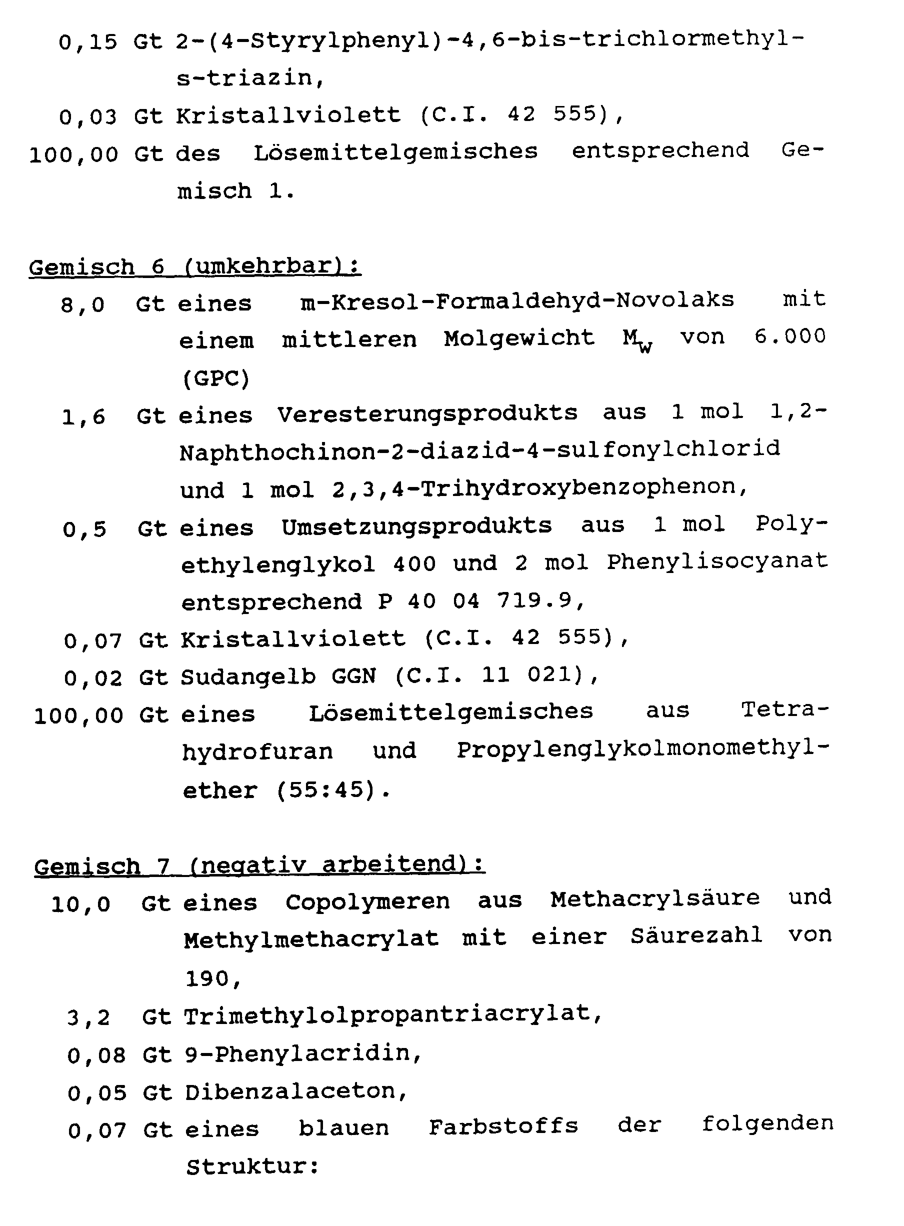

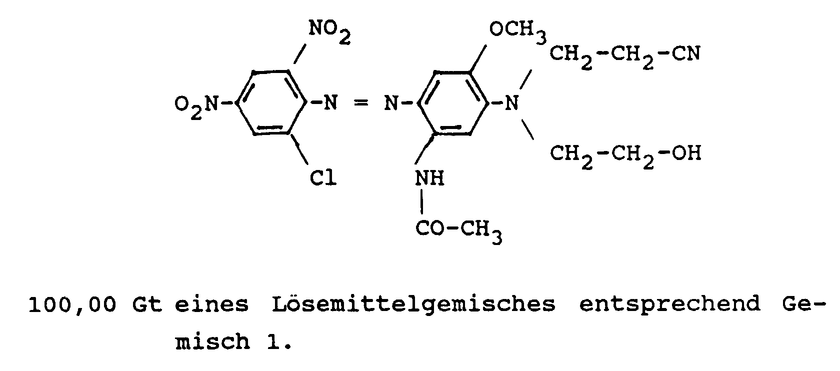

### Aufrauhung der Trägermaterialien:

- für Gemisch 1:: Salzsäure
- für Gemisch 2:: Salzsäure
- für Gemisch 3:: Salpetersäure
- für Gemisch 4:: Salzsäure
- für Gemisch 5:: Naßbürstung
- für Gemisch 6:: Kombination von Naßbürstung und Salzsäureaufrauhung
- für Gemisch 7:: Salzsäure

### Beispiel 1: Positivverarbeitung von Kopierschichten mit 1,2-Chinondiaziden

Das entsprechend Tabelle 1 hergestellte Aufzeichnungsmaterial Nr. 3 wird unter einer 5-kW-Metallhalogenidlampe im Abstand von 110 cm durch einen Halbtonstufenkeil mit 13 Dichtestufen von je 0,15 (Belichtungskeil "BK 01" der Hoechst AG) 60 s lang belichtet und dann in einem Entwickler entsprechend Tabelle 2 entwickelt.

Folgende Prüfkriterien werden untersucht:
1. offene Stufe und Gradation (Zahl der Übergangsstufen von vollgedeckt bis offen) nach einer Regelentwicklungszeit von 30 Sekunden,
2. 5-Sekunden-Entwicklung zur Prüfung des Aufentwicklungverhaltens (bewertet wird das Auftreten von Ton,
3. Entwicklerergiebigkeit in der Art, daß nach Belastung des Entwicklers mit 10 m² Kopierschicht/1 l Entwickler geprüft wird, ob eine tonfreie Entwicklung noch möglich ist,
4. Entwicklerresistenz in der Art, ob bei einer dreifachen Entwicklungszeit (Überentwicklung von einer Minute) eine Schädigung der Feinrasterpartien eines aufkopierten Rasterkeils festzustellen ist,
5. Behinderung einer einwandfreien Entwicklung durch Schaum- oder Fladenbildung.

Die Ergebnisse sind in Tabelle 3 zusammengefaßt.

Sie zeigen, daß bei den erfindungsgemäß zusammengesetzten Entwicklerlösungen kurze Entwicklungszeiten, hohe Ergiebigkeiten und harte Gradation erreicht werden, ohne daß die Entwicklerresistenz beeinträchtigt ist oder eine Störung des Entwicklungsverhaltens auftritt, während bei den zum Vergleich untersuchten Entwicklern mindestens eine dieser Forderungen nicht erfüllt ist.

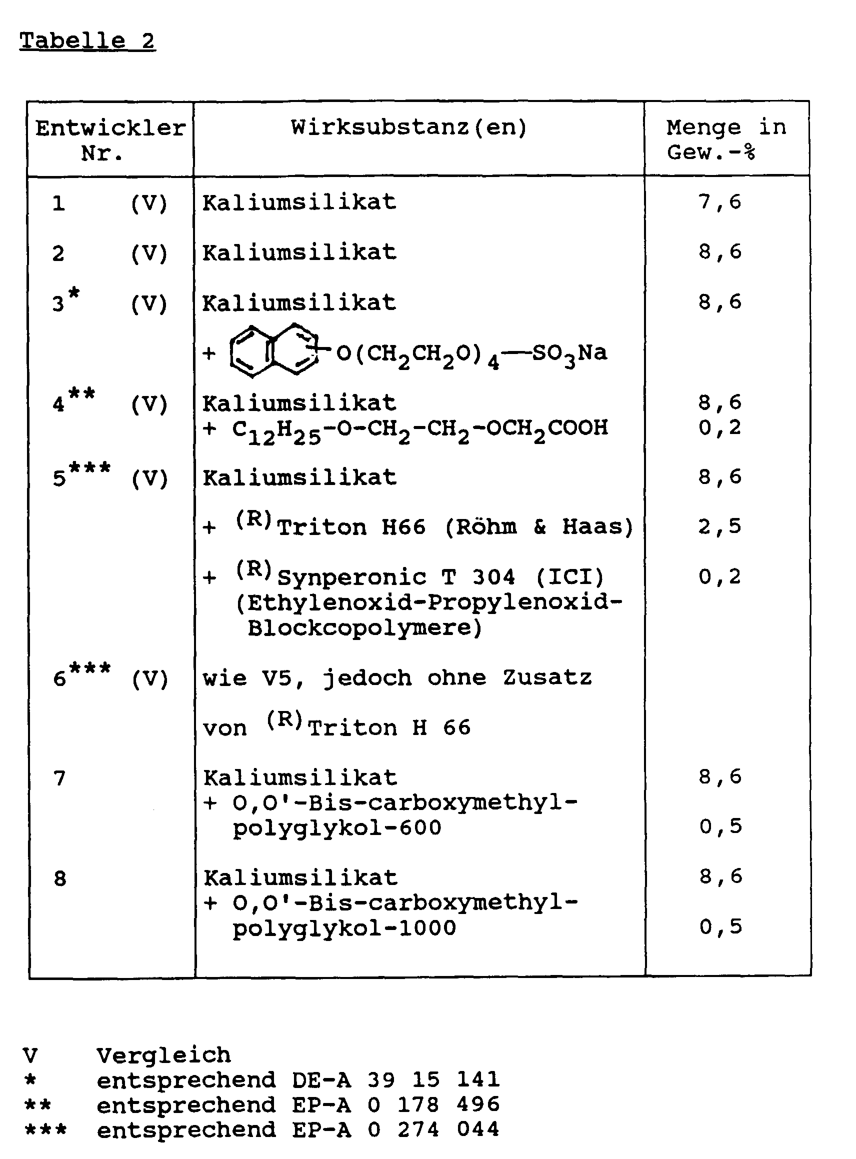

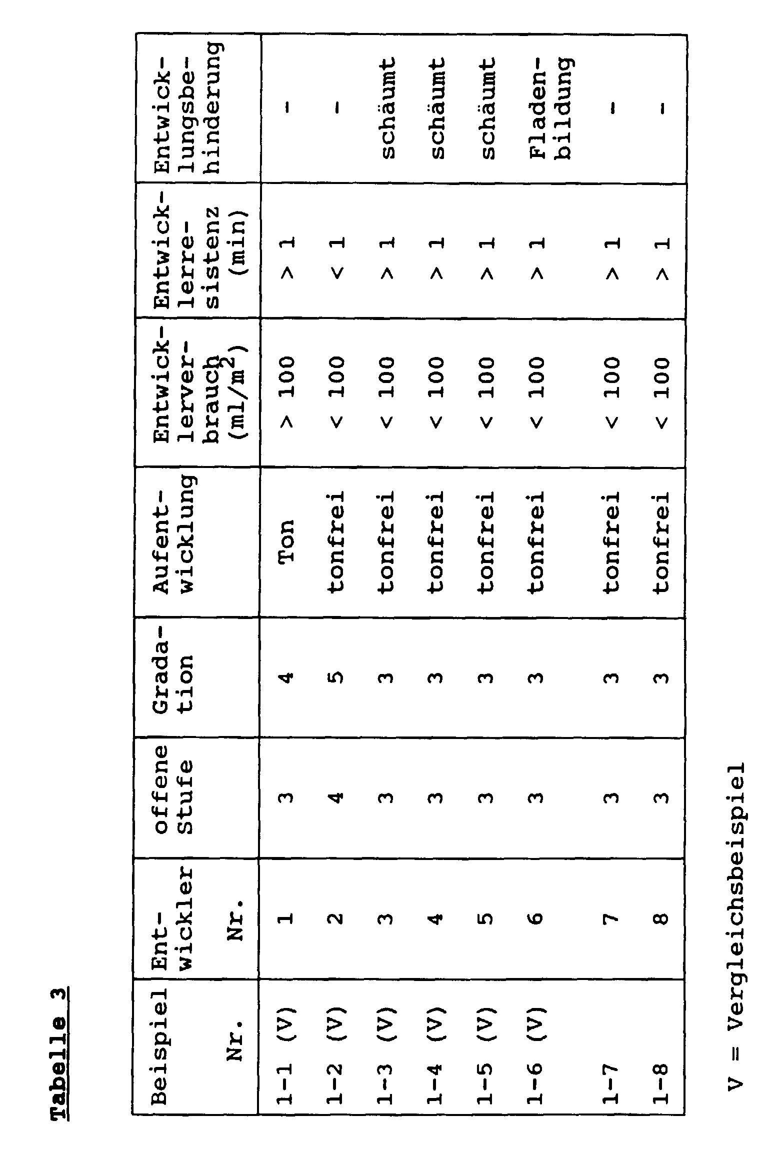

### Beispiel 2: Positivverarbeitung verschiedener Kopierschichten mit 1,2-Chinondiaziden

Entsprechend Tabelle 1 hergestellte Aufzeichnungsmaterialien werden wie in Beispiel 1 belichtet, entwickelt und bewertet. Die Tabelle 4 gibt die erhaltenen Ergebnisse wieder und zeigt, daß auch bei Einsatz unterschiedlicher Kopierschichtzusammensetzungen (bezüglich 1,2-Chinondiazidverbindung, Kontrastbildner, Farbstoff, Umkehrzusatz) hervorragende Resultate mit den erfindungsgemäß zusammengesetzten Entwicklerlösungen erhalten werden.

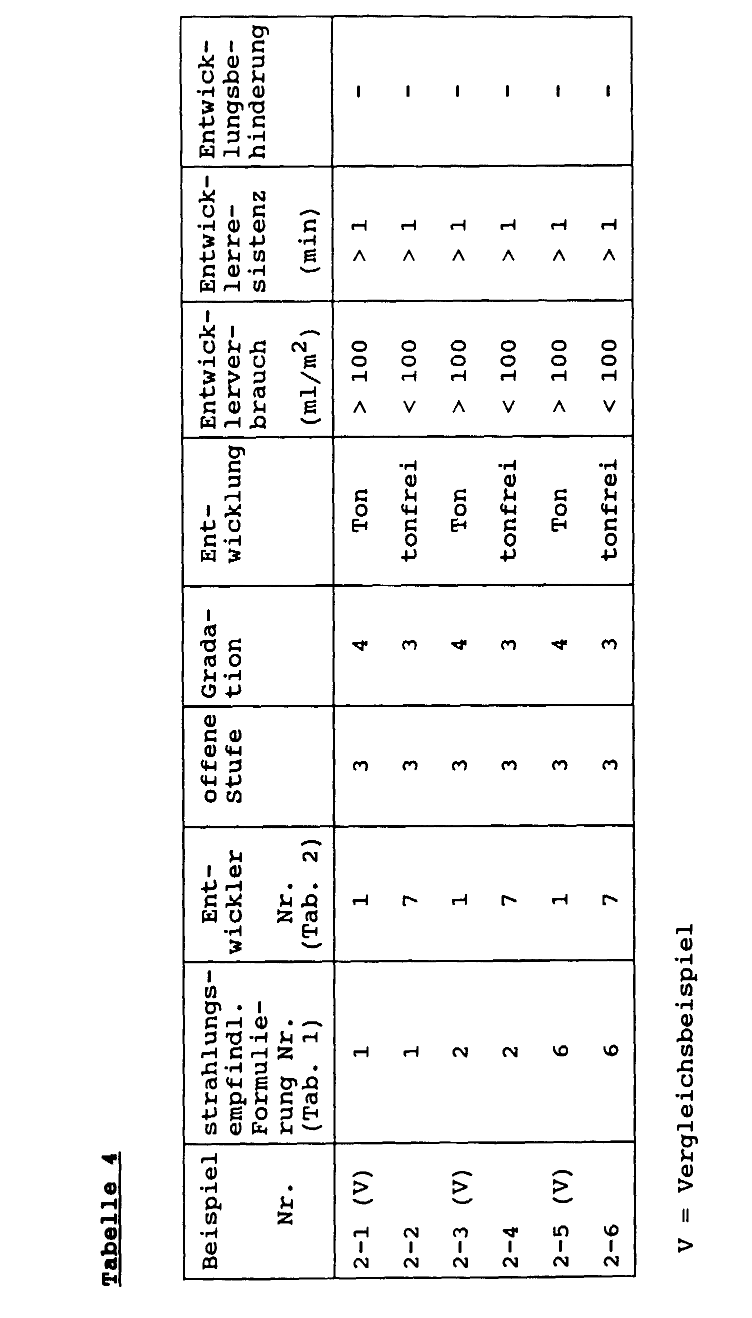

### Beispiel 3: Umkehrverarbeitung

Die Umkehrverarbeitung mit umkehrbaren Kopierschichten entsprechend Tabelle 1 wird auf folgende Art und Weise geprüft: Die Aufzeichnungsmaterialien werden wie in Beispiel 1 40 Sekunden lang belichtet, dann 2 Minuten bei 130 °C in einem Umluftofen konvertiert, 40 Sekunden lang ohne Vorlage ausbelichtet und dann entwickelt. Bewertet werden:
1. voll gedeckte Stufe,
2. Entwicklung,
3. Entwicklerresistenz,
4. Entwicklerergiebigkeit,
5. Störungen beim Entwicklungsprozeß
nach den Maßstäben wie in Beispiel 1 erläutert.

Die Ergebnisse sind in Tabelle 5 zusammengestellt. Es zeigt sich wiederum, daß bei den Vergleichsentwicklern mindestens eine der wesentlichen Forderungen nicht erfüllt ist.

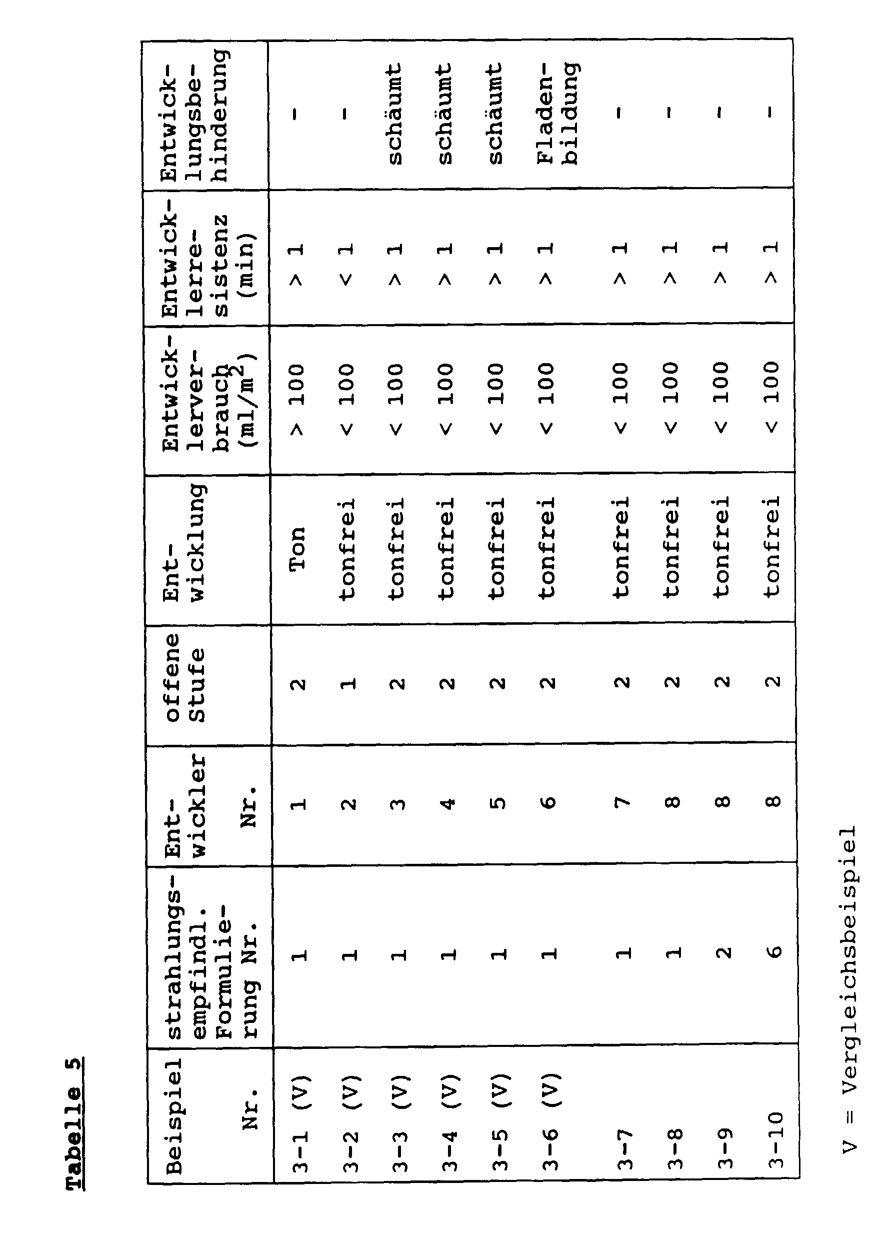

### Beispiel 4: Mischverarbeitung Positiv-Negativ

Mit den strahlungsempfindlichen Formulierungen Nr. 4, 5 und 7 wird eine Positiv-Negativ-Umkehr-Mischverarbeitung durchgeführt.

Umkehrverarbeitung mit Formulierung Nr. 4:
1. Bildmäßige Belichtung durch Halbtonstufenkeil, 20 Sekunden,
2. Konvertierung 2 Minuten bei 135 °C in einem Umluftofen,
3. Ausbelichtung ohne Vorlage, 40 Sekunden

Positivverarbeitung mit Formulierung Nr. 5:
1. Bildmäßige Belichtung, 20 Sekunden,
2. Einminütige Temperung bei 80 °C zur Vervollständigung der Acetalhydrolyse.

Negativverarbeitung mit Formulierung Nr. 7:
1. Bildmäßige Belichtung, 40 Sekunden

Vor der Entwicklung wird die Polyvinylalkohol-Deckschicht mit H₂O abgespült. Für die Entwicklung werden die Entwickler aufgrund der hohen Hydroxyl- bzw. Säurezahl der in den Formulierungen eingesetzten Bindemittel mit vollentsalztem Wasser im Verhältnis 1:2 verdünnt. Beurteilt wird, ob bei der Mischverarbeitung eine Beeinträchtigung der Entwicklung in Form von Fladenbildung (F), Schaumbildung (S) sowie verzögerter oder ungleichmäßiger Entwicklung (-) festzustellen ist oder ob die Entwicklung ohne Probleme (+) erfolgt.

Die Ergebnisse sind in Tabelle 6 festgehalten und belegen, daß mit den erfindungsgemäßen Entwicklern eine unproblematische Mischverarbeitung möglich ist.

**Tabelle 6**

| Beispiel Nr. | Entwickler Nr. | strahlungsempfindliche Formulierungen Nr. | | |
|---|---|---|---|---|
| | | 4 (Umkehr) | 5 (Positiv) | 7 (Negativ) |
| 4-1 (V) | 1 | - | + | - |
| -2 (V) | 2 | + | + | - |
| -3 (V) | 3 | S | S | S |
| -4 (V) | 4 | S | S | S |
| -5 (V) | 5 | S | S | S |
| -6 (V) | 6 | F | F | + |
| -7 | 7 | + | + | + |
| -8 | 8 | + | + | + |
| (V) = Vergleichsbeispiel | | | | |

## Patentansprüche

1. Entwicklerzusammensetzung für strahlungsempfindliche, positiv und negativ arbeitende sowie umkehrbare reprographische Schichten, die als wesentlichen Bestandteil neben der strahlungsempfindlichen Verbindung oder Kombination von Verbindungen ein in Wasser unlösliches, in wäßrig-alkalischen Lösungen aber lösliches Bindemittel enthalten, dadurch gekennzeichnet, daß der Entwickler als wesentliche Bestandteile
a) O-Carboxymethyl- oder O,O'-Bis-carboxymethylethylenglykol oder ein O-Carboxymethyl- oder O,O'-Bis-carboxymethyl-polyethylenglykol mit 2 bis etwa 500 Ethylenglykol-Einheiten,
b) mindestens eine in wäßriger Lösung alkalisch reagierende Verbindung aus der Gruppe der Alkali- und Ammoniumhydroxide, -silikate, -phosphate und -borate und
c) Wasser
enthält.

2. Entwicklerzusammensetzung nach Anspruch 1, dadurch gekennzeichnet, daß die substituierten Polyethylenglykole etwa 5 bis etwa 50 Ethylenglykoleinheiten enthalten.

3. Entwicklerzusammensetzung nach Anspruch 1 oder 2, dadurch gekennzeichnet, daß sie einen Gehalt an veretherten (Poly-)ethylenglykolen im Bereich von 0,01 bis 20 Gew.-%, bezogen auf das Gesamtgewicht der Zusammensetzung, aufweist.

4. Entwicklerzusammensetzung nach den Ansprüchen 1 bis 3, dadurch gekennzeichnet, daß die alkalisch reagierende Substanz ein Alkali- oder Ammoniumhydroxid oder -silikat ist.

5. Entwicklerzusammensetzung nach den Ansprüchen 1 bis 4, dadurch gekennzeichnet, daß der Entwickler zusätzlich zu den Verbindungen a) bis c) ein organisches Lösemittel enthält.

6. Entwicklerzusammensetzung nach den Ansprüchen 1 bis 5, dadurch gekennzeichnet, daß der Entwickler mindestens ein Tensid aus der Gruppe der kationischen, anionischen, nichtionischen oder zwitterionischen Tenside enthält.

7. Entwicklerzusammensetzung nach den Ansprüchen 1 bis 6, dadurch gekennzeichnet, daß der Entwickler ein Sequestrierungsmittel enthält.

8. Entwicklerzusammensetzung nach den Ansprüchen 1 bis 7, dadurch gekennzeichnet, daß der Entwickler einen Korrosionsinhibitor enthält.

9. Entwicklerzusammensetzung nach den Ansprüchen 1 bis 8, dadurch gekennzeichnet, daß der Entwickler eine hydrotrope Substanz enthält.

10. Entwicklerzusammensetzung nach den Ansprüchen 1 bis 9, dadurch gekennzeichnet, daß der Entwickler ein Antischaummittel enthält.

11. Verfahren zur Entwicklung von bildmäßigen belichteten strahlungsempfindlichen, positiv und negativ arbeitenden sowie umkehrbaren reprographischen Schichten, die als wesentlichen Bestandteil neben der strahlungsempfindlichen Verbindung oder Kombination von Verbindungen ein in Wasser unlösliches, in wäßrig-alkalischen Lösungen aber lösliches Bindemittel enthalten, dadurch gekennzeichnet, daß zur Entwicklung eine Entwicklerzusammensetzung entsprechend einem oder mehreren der Ansprüche 1 bis 10 verwendet wird.

12. Verfahren nach Anspruch 11, dadurch gekennzeichnet, daß die Entwicklung bei Temperaturen zwischen 18 und 50 °C über eine Dauer von 5 Sekunden bis zu einer Minute erfolgt.

## Claims

1. Developer composition for radiation-sensitive, positive- and negative-working as well as reversible reprographic layers which contain as an essential component, in addition to the radiation-sensitive compound or combination of compounds, a binder which is insoluble in water but soluble in aqueous-alkaline solutions, characterised in that the developer contains as essential components
a) O-carboxymethyl ethylene glycol or O,O'-bis-carboxymethyl ethylene glycol or an O-carboxymethyl polyethylene glycol or O,O'-bis-carboxymethyl polyethylene glycol having from 2 to about 500 ethylene glycol units,
b) at least one compound which reacts alkaline in aqueous solution, selected from among the alkali hydroxides and ammonium hydroxide, the alkali and ammonium silicates, phosphates and borates and
c) water.

2. Developer composition according to claim 1, characterised in that the substituted polyethylene glycols contain from about 5 to about 50 ethylene glycol units.

3. Developer composition according to claim 1 or 2, characterised in that it has a content of etherified (poly)ethylene glycols in the range of 0.01 to 20 wt.%, based on the total weight of the composition.

4. Developer composition according to claims 1 to 3, characterised in that the substance which reacts alkaline is an alkali hydroxide or ammonium hydroxide or alkali silicate or ammonium silicate.

5. Developer composition according to claims 1 to 4, characterised in that the developer contains an organic solvent in addition to compounds a) to c).

6. Developer composition according to claims 1 to 5, characterised in that the developer contains at least one surfactant selected from among the cationic, anionic, nonionic or zwitterionic surfactants.

7. Developer composition according to claims 1 to 6, characterised in that the developer contains a sequestrant.

8. Developer composition according to claims 1 to 7, characterised in that the developer contains a corrosion inhibitor.

9. Developer composition according to claims 1 to 8, characterised in that the developer contains a hydrotrope.

10. Developer composition according to claims 1 to 9, characterised in that the developer contains an antifoaming agent.

11. A process for the development of imagewise exposed, radiation-sensitive, positive- and negative-working as well as reversible reprographic layers which contain as an essential component, in addition to the radiation-sensitive compound or combination of compounds, a binder which is insoluble in water but soluble in aqueous-alkaline solutions, characterised in that a developer composition corresponding to one or more of claims 1 to 10 is used for the development.

12. A process according to claim 11, characterised in that the development is carried out at temperatures of between 18°C and 50°C for a duration of 5 seconds up to one minute.

## Revendications

1. Composition d'agent de développement pour couches reprographiques sensibles au rayonnement, à effet positif et négatif et pour couches reprographiques sensibles au rayonnement inversibles, qui contiennent comme constituant essentiel, outre le composé sensible au rayonnement ou une combinaison de composés sensibles au rayonnement, un liant insoluble dans l'eau mais soluble dans les solutions alcalines aqueuses, caractérisée en ce que l'agent de développement contient comme constituants essentiels
a) du O-carboxyméthyl- ou O,O'-bis-carboxyméthyléthylèneglycol ou un O-carboxyméthyl- ou un O,O'-bis-carboxyméthylpolyéthylèneglycol ayant 2 à environ 500 unités d'éthylèneglycol,
b) au moins un composé à réaction alcaline en solution aqueuse du groupe des hydroxydes, silicates, phosphates et borates alcalins et d'ammonium, et
c) de l'eau.

2. Composition d'agent de développement selon la revendication 1, caractérisée en ce que les polyéthylèneglycols substitués contiennent environ 5 à environ 50 unités d'éthylèneglycol.

3. Composition d'agent de développement selon la revendication 1 ou 2, caractérisée en ce qu'elle présente une teneur en (poly)éthylèneglycols éthérifiés dans le domaine de 0,01 à 20 % en masse par rapport à la masse totale de la composition.

4. Composition d'agent de développement selon les revendications 1 à 3, caractérisée en ce que la substance à réaction alcaline est un hydroxyde ou silicate alcalin ou d'ammonium.

5. Composition d'agent de développement selon les revendications 1 à 4, caractérisée en ce que l'agent de développement contient un solvant organique en plus des composés a) à c).

6. Composition d'agent de développement selon les revendications 1 à 5, caractérisée en ce que l'agent de développement contient au moins un tensioactif du groupe des tensioactifs cationiques, anioniques, non ioniques ou zwitterioniques.

7. Composition d'agent de développement selon les revendications 1 à 6, caractérisée en ce que l'agent de développement contient un agent séquestrant.

8. Composition d'agent de développement selon les revendications 1 à 7, caractérisée en ce que l'agent de développement contient un inhibiteur de corrosion.

9. Composition d'agent de développement selon les revendications 1 à 8, caractérisée en ce que l'agent de développement contient une substance hydrotrope.

10. Composition d'agent de développement selon les revendications 1 à 9, caractérisée en ce que l'agent de développement contient un antimousse.

11. Procédé de développement de couches reprographiques sensibles au rayonnement positives et négatives et de couches reprographiques sensibles au rayonnement inversibles insolées suivant une image, qui contiennent comme constituant essentiel, outre le composé sensible au rayonnement ou une combinaison de composés sensibles au rayonnement, un liant insoluble dans l'eau mais soluble dans les solutions alcalines aqueuses, caractérisé en ce qu'une composition d'agent de développement selon une ou plusieurs des revendications 1 à 10 est utilisée pour le développement.

12. Procédé selon la revendication 11, caractérisé en ce que le développement a lieu à des températures comprises entre 18 et 50°C pendant une durée de 5 s à 1 min.
